# EUROPÄISCHE PATENTANMELDUNG

(11) **EP 0 753 815 A2**
(43) Veröffentlichungstag der Anmeldung: **15.01.1997**
(21) Anmeldenummer: 96110635.8
(22) Anmeldetag: 02.07.1996
(51) Int. Cl.: G06F 11/18, G06F 11/00

(54) **Verfahren zum selbsttätigen Erkennen und Korrigieren eines ungültigen Datensatzes und System zu seiner Durchführung**

(30) Priorität: 11.07.1995 DE 19525149
(71) Anmelder: TEMIC TELEFUNKEN microelectronic GmbH, 74072 Heilbronn (DE)
(72) Erfinder: Fendt, Günter, 86529 Schrobenhausen (DE); Hora, Peter, 86529 Schrobenhausen (DE); Spies, Hans, 85276 Pfaffenhofen (DE); Wetzel, Guido, 86533 Neuburg (DE); Zechmair, Derrick, 86529 Schrobenhausen (DE)
(74) Vertreter: Maute, Hans-Jürgen, Dipl.-Ing.

(57) **Zusammenfassung**

Die Erfindung betrifft ein Verfahren zum selbsttätigen Erkennen und Korrigieren eines ungültigen, in einem schaltungsprogrammierbaren Speicher gespeicherten Datensatzes, der Teil einer Gruppe wenigstens dreifach identisch hinterlegter Datensätze ist, wobei die Datensätze der Gruppe miteinander verglichen werden, bei Nichtübereinstimmung eines Datensatzes der Gruppe mit den übrigen Datensätzen der Gruppe dieser als ungültig erkannt wird und die übrigen, übereinstimmenden Datensätze als gültig erkannt werden, und der ungültige Datensatz korrigiert wird, indem er durch einen gültigen Datensatz ersetzt wird. Die Erfindung ist auch auf ein zur Durchführung dieses Verfahrens geeignetes System gerichtet.

## Beschreibung

Die Erfindung betrifft ein Verfahren zum selbsttätigen Erkennen und Korrigieren eines ungültigen, in einem schaltungsprogrammierbaren Speicher gespeicherten Datensatzes, der Teil einer Gruppe wenigstens dreifach identisch hinterlegter Datensätze ist.

Für den Betrieb vieler elektronischer Geräte, z. B. eines Steuergeräts in einem Kraftfahrzeug, werden nichtflüchtig gespeicherte Daten benötigt. Im allgemeinen fällt ein Teil dieser Daten erst während des Betriebs bzw. bei der ersten Inbetriebnahme an; bei einem Kraftfahrzeug sind dies z. B. Kalibrierdaten, Fehlerdaten, Systemuhrdaten und bestimmte fahrzeugspezifische Daten. Solche Daten können also nicht in einem bereits herstellerseitig programmierten Speicher (ROM) abgelegt werden. Vielmehr ist für sie ein in der Schaltung programmierbarer nichtflüchtiger Speicher vorzusehen. Hierbei kann es sich z. B. um einen EEPROM (elektrisch löschbaren Festwertspeicher), einen mit einem EEPROM kombinierten RAM (flüchtigen Schreib-Lese-Speicher) oder einen batteriegepufferten RAM handeln.

Obwohl derartige Speicher im allgemeinen recht zuverlässig sind kann es doch vorkommen, daß einzelne Speicherzellen "umkippen", d. h. von selbst einen anderen als den ursprünglich hinterlegten Inhalt annehmen. Aus sicherheitstechnischen Gründen werden deshalb systemkritische und andere wichtige Daten in der Regel mehrfach abgespeichert, um durch deren Vergleich eine Eigendiagnose des Speichers zu erlauben. Bei Kraftfahrzeug-Steuergeräten ist es beispielsweise bekannt, jeden Datensatz zunächst dreifach abzuspeichern und bei der Diagnose die Identität der Datensätze einer solchen Dreiergruppe zu überprüfen. Stimmt ein Datensatz einer Gruppe mit den beiden übrigen Datensätzen der Gruppe nicht überein, so werden die beiden übereinstimmenden Datensätze als gültig erkannt, was einen vorübergehenden Weiterbetrieb des Fahrzeugs ermöglicht. Außerdem wird eine Fehlermeldung gegeben, z. B. durch Ansteuern einer Fehlerlampe, um dem Benutzer mitzuteilen, daß im System ein Speicherfehler vorliegt. Das Steuergerät mit dem Speicherfehler muß dann ausgetauscht werden, da es sich bei diesem Fehler um einen internen Systemfehler handelt, der nicht vom Benutzer und auch nicht z. B. von einer Kraftfahrzeug-Werkstatt behoben werden kann.

Dies gibt zwar eine ausreichende Sicherheit im Fall eines Umkippens von Speicherzellen, bringt jedoch wegen des nötigen Austauschs des betroffenen Steuergeräts und des dazu erforderlichen Aufsuchens einer Werkstatt einen erheblichen Aufwand und Unannehmlichkeiten für den Benutzer mit sich.

Die Erfindung geht von dem technischen Problem aus, diese Nachteile zu überwinden.

Sie löst dieses Problem durch ein Verfahren zum selbsttätigen Erkennen und Korrigieren eines ungültigen, in einem schaltungsprogrammierbaren Speicher gespeicherten Datensatzes, der Teil einer Gruppe wenigstens dreifach identisch hinterlegter Datensätze ist, wobei:
a) die Datensätze der Gruppe miteinander verglichen werden;
b) bei Nichtübereinstimmung eines Datensatzes der Gruppe mit den übrigen Datensätzen der Gruppe dieser als ungültig erkannt wird und die übrigen, übereinstimmenden Datensätze der Gruppe als gültig erkannt werden; und
c) der ungültige Datensatz korrigiert wird, indem er durch einen gültigen Datensatz ersetzt wird.

Diese Lösung hat die folgenden Vorteile:
- ein Umkippen einer Speicherzelle führt nicht mehr zu einem Systemfehler;
- das betroffene Steuergerät braucht nicht mehr ausgetauscht zu werden;
- die Notwendigkeit eines Werkstattbesuchs entfällt; und
- eine Betriebsart mit verringerter Sicherheit, wie sie etwa beim Stand der Technik in dem Zeitraum zwischen dem Umkippen einer Speicherzelle und dem dann nötigen Steuergerättausch vorliegt, wird vermieden.

Ingesamt erfordert sie weniger Aufwand, bringt für den Benutzer weniger Unannehmlichkeiten mit sich und bedingt eine weitere Erhöhung der Sicherheit.

Eine besonders einfache Korrektur des ungültigen Datensatzes stellt es dar, den neuen, gültigen Datensatz in dieselbe Speicherzelle zu schreiben, in der sich der ungültige befindet.

Alternativ kann man den neuen gültigen Datensatz auch in einer anderen Speicherzelle hinterlegen. Dies ist zwar etwas aufwendiger, da es auch eine Änderung einer Zuordnungstabelle, die angibt, in welchen Speicherzellen sich welche Datensätze befinden, erforderlich macht. Andererseits erhöht es die Sicherheit, da ein erneutes Umkippen dort mit geringerer Wahrscheinlichkeit als in der ursprünglichen, möglicherweise defekten Speicherzelle auftreten wird. Vorteilhaft belegt man eine Speicherzelle, die einmal (oder mehrmals) umgekippt ist, nicht mehr neu.

Um die Wahrscheinlichkeit eines wiederholten Umkippens weiter zu verringern, wählt man die andere Speicherzelle vorzugsweise in einem anderen Gebiet des Speicherbauelements oder in einem anderen Speicherbauelement. Denn die Fehlerwahrscheinlichkeit ist - bedingt durch Fertigungsmängel und Verunreinigungen - räumlich korreliert, so daß eine Speicherzelle in einem räumlich entfernten Gebiet oder einem anderen Speicherbauelement seltener nochmals umkippen wird als eine nahegelegene. Der andere Speicherbaustein kann z. B. auch ein Teil eines Mikrocontrollers im selben Steuergerät oder kann - Vernetzung vorausgesetzt - in einem anderen Steuergerät liegen.

Vorteilhaft wiederholt man das Erkennungs- und Korrekturverfahren für verschiedene Gruppen identisch hinterlegter Datensätze. Im Beispiel eines Kraftfahrzeug-Steuergeräts überprüft man vorzugsweise alle gespeicherten Datensätze während der Eigendiagnose beim Einschalten des Systems bzw. Laufen.

Bei dem wiederholt ausgeführten Verfahren ist es besonders vorteilhaft, die beiden oben genannten Alternativen zum Ersetzen des ungültigen Datensatzes (nämlich Umprogrammieren derselben Speicherzelle oder Ablegen in einer anderen Speicherzelle) zu kombinieren: Zunächst erlaubt man, daß ein und dieselbe Speicherzelle mehrmals umprogrammiert wird, wobei man jedoch für jede Speicherzelle zählt, wie oft dies geschieht. Wenn diese Zahl eine vorgegebene Maximalanzah von Korrekturzyklen für diese einzelne Speicherzelle überschreitet, wird sie nicht weiter umprogrammiert. Der neue Datensatz wird dann in einer anderen Speicherzelle, insbesondere in einem anderen Gebiet des Speicherbauelements oder in einem Speicherbauelement hinterlegt. Im allgemeinen Fall ist jeder Speicherzelle eine eigene Maximalanzahl vorgegeben, es kann aber auch für alle Speicherzellen die gleiche Maximalanzahl vorgegeben sein. Bei einer alternativen Ausbildung wird - wie oben - die Anzahl der Korrekturzyklen für jede Speicherzelle gezählt; bei Überschreiten der Maximalanzahl wird jedoch eine Fehlermeldung abgegeben und ggf. das Verfahren abgebrochen. Das betroffene Gerät muß dann ausgetauscht werden.

In besonderen Fällen, z. B. bei einem oder mehreren im ganzen schadhaften Speicherbausteinen, kann insgesamt eine sehr große Anzahl von Korrekturzyklen auftreten. Um dies zu erkennen, wird vorteilhaft die Gesamtzahl von Korrekturzyklen im System gezählt (d. h. es wird die Summe der Korrekturzyklen für die einzelnen Zellen gebildet) und, wenn sie eine hierfür vorgegebene Maximalanzahl überschreitet, eine Fehlermeldung abgegeben und ggf. das Verfahren abgebrochen. Auch dann muß das betroffene Gerät ausgetauscht werden.

Die Erfindung ist auch auf ein System zur Durchführung des obigen Verfahrens gerichtet, mit:
- einem schaltungsprogrammierbaren Speicher;
- einem Mittel zum Vergleichen der Datensätze einer Gruppe;
- einem Mittel, das dazu eingerichtet ist, bei Nichtübereinstimmung eines Datensatzes der Gruppe mit den übrigen Datensätzen der Gruppe diesen als ungültig zu erkennen und die übrigen, übereinstimmenden Datensätze als gültig zu erkennen; und
- einem Mittel zum Korrigieren des ungültigen Datensatzes durch Ersetzen durch einen gültigen Datensatz.

Grundsätzlich kann das System aus mehreren "festverdrahteten" Funktionseinheiten aufgebaut sein, die die Aufgabe des Vergleichens, Erkennens und Korrigierens von Datensätzen, Zählens von Korrekturzyklen, Abgebens von Fehlermeldungen oder Abbrechens des Verfahrens erfüllen. Bevorzugt werden diese Mittel jedoch durch wenigstens einen geeignet programmierten Mikrocomputer gebildet. Der Speicher kann selbst einen Teil des Mikrocomputers bilden. Der Mikrocomputer kann auch aus einem oder mehreren Mikrocontrollern bestehen. In diesem Fall kann der Speicher sogar in einem Bauelement mit einer die obigen Aufgaben übernehmenden Prozessoreinheit integriert sein.

Weitere bevorzugte Ausgestaltungen dieses Systems sind in den System-Unteransprüchen angegeben. Näheres hierzu findet sich in den obigen Erläuterungen.

Die Erfindung wird nun anhand von Ausführungsbeispielen und der angefügten schematischen Zeichnung näher erläutert. In der Zeichnung zeigen:
- Figur 1: ein Ablaufschema eines Erkennungs- und Korrekturverfahrens, das insbesondere in einem Kraftfahrzeug-Steuergerät durchgeführt wird; und
- Figur 2: ein Blockschema eines Erkennungs- und Korrektursystems, das insbesondere einen Teil eines Kraftfahrzeug-Steuergeräts bildet.

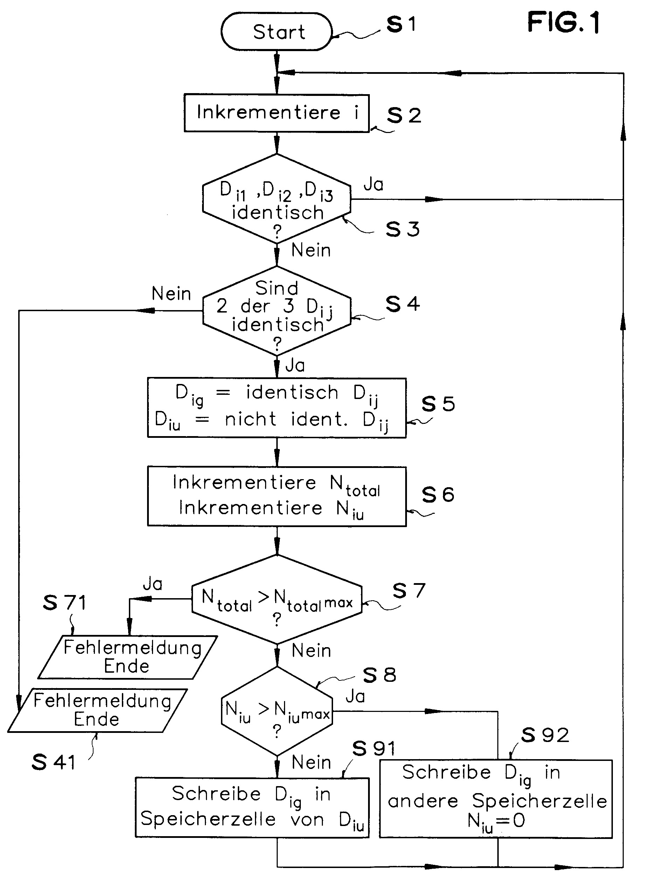

Das Verfahren gemäß Figur 1 mündet nach dem Start (Schritt S1) und einem (nicht gezeigten) Initialisieren (d. h. auf Null setzen) eines Indexes i, der die gerade behandelte Datensatzgruppe kennzeichnet, in eine Endlos-Schleife.

Im ersten Schritt S2 dieser Endlos-Schleife wird der Gruppenindex i inkrementiert, d. h. um Eins erhöht. Dabei wird er nach Erreichen der Gesamtzahl von Gruppen nicht weiter erhöht, sondern auf Eins zurückgesetzt.

Im folgenden Erkennungsteil des Verfahrens werden im Schritt S3 die drei Datensätze Dᵢ₁, Dᵢ₂, Dᵢ₃ der Gruppe i miteinander verglichen. Im Fall von Identität - dem Regelfall - liegt kein Umkippen vor. Ein Durchgang der Endlos-Schleife ist dann beendet, der Ablauf mündet zur Behandlung der nächsten Gruppe wieder vor dem obigen Schritt S2 ein.

Falls hingegen eine oder zwei der Speicherzellen umgekippt sind, also im Schritt S3 "Nichtidentität" gefunden wird, folgt ein weiterer Vergleichsschritt S4. Darin wird geprüft, ob wenigstens zwei der drei Datensätze der Gruppe i identisch sind. Falls dies nicht der Fall ist, d. h. zwei Speicherzellen umgekippt sind, wird die Endlos-Schleife an dieser Stelle verlassen. Es folgt dann in einem Schritt S41 eine entsprechende Fehlermeldung und ein Abbruch des Verfahrens.

Falls jedoch - wie im häufigeren Fall - wenigestens zwei der mindestens drei Datensätze identisch sind, d. h. nur eine Speicherzelle umgekippt ist, werden im Schritt S5 die beiden übereinstimmenden Datensätze als gültig D_{ig} und der nicht mit ihnen übereinstimmende Datensatz als ungültig Dᵢᵤ erkannt.

Im folgenden Korrekturteil des Verfahrens wird zunächst im Schritt S6 jeweils ein Zähler Nₜₒₜₐₗ für die Gesamtzahl von Korrekturzyklen und ein Zähler Nᵢᵤ für die Anzahl der Korrekturzyklen der den ungültigen Datensatz enthaltenden Speicherzelle inkrementiert. Vor der erstmaligen Inbetriebnahme des Steuergeräts sind der Zähler Nₜₒₜₐₗ und alle Zähler Nᵢᵤ initialisiert worden.

Im nächsten Schritt S7 wird abgefragt, ob die Gesamtzahl der Korrekturzyklen Nₜₒₜₐₗ eine hierfür vorgegebene Maximalanzahl N_{total,max} übersteigt. Falls ja, ist das Steuergerät fehlerhaft und die Endlos-Schleife wird an dieser Stelle verlassen. Im dann noch folgenden Schritt S71 wird eine entsprechende Fehlermeldung erzeugt und das Verfahren zum Abbruch gebracht.

Falls nein, wird im Schritt S8 abgefragt, ob die Anzahl N von Korrekturzyklen für die betroffene Speicherzelle eine hierfür vorgegebene Maximalanzahl N_{iu,max} übersteigt. Diese N_{iu,max} Maximalanzahl ist vorteilhaft für alle Speicherzellen gleich und kann einen Wert von zwei bis sechs, vorzugsweise den Wert drei haben.

Falls die Antwort im Schritt S8 "Nein" ist, wird im dann folgenden Schritt S91 der als gültig erkannte Datensatz D_{ig} in die Speicherzelle geschrieben, in der sich der ungültige Datensatz befindet. Damit ist ein Durchlauf der Endlos-Schleife beendet und das Verfahren mündet zur Behandlung der nächsten Gruppe wieder oben vor dem Schritt S2 ein.

Falls hingegen die Antwort im Schritt S8 "Ja" ist, wird im dann folgenden Schritt S92 der als gültig erkannte Datensatz D_{ig} in eine andere Speicherzelle geschrieben und der Zähler Nᵢᵤ auf Null gesetzt. Dabei wird auch eine Zuordnungstabelle, die angibt, in welchen Speicherzellen sich welche Datensätze befinden, entsprechend dem Wechsel der Speicherzelle geändert. Es ist auch vorteilhaft, diejenigen Speicherzellen, die auf diese Weise verlassen wurden, in einer Merktabelle festzuhalten und im weiteren Verlauf des Verfahrens jeweils durch Abfragen dieser Tabelle sicherzustellen, daß eine solche Speicherzelle nicht mehr neu belegt wird. Nach Vollendung des Schrittes S92 ist ebenfalls ein Durchlauf der Endlos-Schleife beendet, das Verfahren zur Behandlung der nächsten Gruppe wieder oben vor dem Schritt S2 ein.

In einer (nicht gezeigten) alternativen Ausführungsform kann statt des Schrittes S92 auch eine Fehlermeldung erzeugt und das Verfahren zum Abbruch gebracht werden.

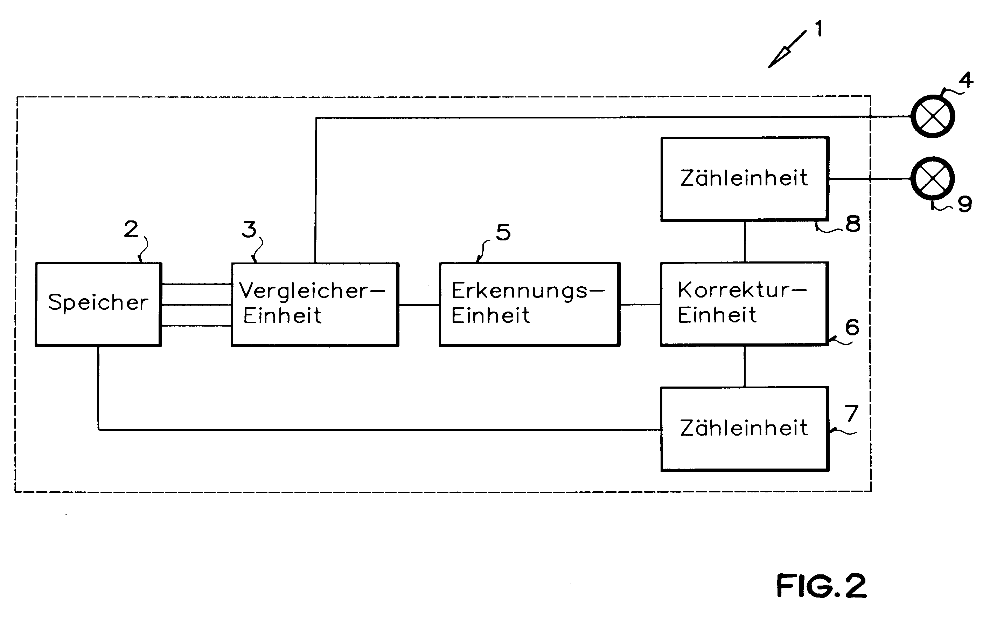

Das in Figur 2 gezeigte Erkennungs- und Korrektursystem 1 ist ein Beispiel für ein aus festverdrahteten Funktionseinheiten aufgebautes System. Es weist einen nichtflüchtigen, in der Schaltung programmierbaren Speicher 2 auf, der beispielsweise durch einen oder mehrere EEPROM-, kombinierte EEPROM-SRAM- oder batteriegepufferte SRAM-Bausteine gebildet wird. Daten können darin jeweils in Gruppen von drei identischen Datensätzen abgespeichert werden.

Der Speicher 2 ist gekoppelt mit einem Mittel 3 zum Vergleichen der Datensätze einer Gruppe, hier einer Vergleichereinheit. Diese kann eine Fehleranzeige 4 ansteuern, um den seltenen Fall zwei umgekippter Speicherzellen einer Gruppe anzeigen zu können. Die Vergleichereinheit 3 ist gekoppelt mit einem Mittel 5, hier einer Erkennungseinheit, die bei Nichtübereinstimmung eines Datensatzes der Gruppe mit den übrigen der Gruppe diesen als ungültig und die übrigen als gültig erkennt. Die Erkennungseinheit 5 ist wiederum gekoppelt mit einem Mittel 6 zum Korrigieren des ungültigen Datensatzes, hier einer Korrektureinheit, die über ein Mittel 7 zum Zählen, hier einer ersten Zähleinheit, mit dem Speicher 2 gekoppelt ist. Die Korrektureinheit 7 korrigiert zunächst einen als ungültig erkannten Datensatz, indem sie den gültigen Datensatz in dieselbe Speicherzelle schreibt. Die erste Zähleinheit 7 zählt dabei, wie oft dies für eine bestimmte Speicherzelle geschieht und veranlaßt bei Überschreiten einer Maximalanzahl, daß der gültige Datensatz in eine andere Speicherzelle geschrieben wird. Um die Anzahl der Korrekturzyklen insgesamt begrenzen zu können, ist die Korrektureinheit 7 noch mit einem Mittel 8 zum Zählen, hier einer zweiten Zähleinheit gekoppelt, die eine zweite Fehleranzeige 9 ansteuern kann. Das System 1 ist so ausgebildet, daß es zur Durchführung des Verfahrens von Figur 1 geeignet ist.

Eine (nicht gezeigte) alternative Ausführungsform des Systems weist anstelle der Einheiten 3, 5, 6, 7 und 8 einen Mikrocomputer auf, der so programmiert ist, daß er das Verfahren von Figur 1 ausführen kann. Er kann neben den zur Ausführung des Verfahrens gehörenden Aufgaben noch weitere haben, so daß es sich bei ihm beispielsweise um den Steuergerät-Mikrocomputer handeln kann.

## Patentansprüche

1. Verfahren zum selbsttätigen Erkennen und Korrigieren eines ungültigen, in einem schaltungsprogrammierbaren Speicher gespeicherten Datensatzes, der Teil einer Gruppe wenigstens dreifach identisch hinterlegter Datensätze ist, wobei:
a) die Datensätze der Gruppe miteinander verglichen werden;
b) bei Nichtübereinstimmung eines Datensatzes der Gruppe mit den übrigen Datensätzen der Gruppe dieser als ungültig erkannt wird und die übrigen, übereinstimmenden Datensätze der Gruppe als gültig erkannt werden; und
c) der ungültige Datensatz korrigiert wird, indem er durch einen gültigen Datensatz ersetzt wird.

2. Verfahren nach Anspruch 1, wobei das Ersetzen des ungültigen Datensatzes in Schritt c) durch Umprogrammieren der Speicherzelle, in der sich dieser befindet, erzielt wird.

3. Verfahren nach Anspruch 1, wobei das Ersetzen des ungültigen Datensatzes in Schritt c) erzielt wird, indem der neue, gültige Datensatz in anderen Speicherzellen hinterlegt wird.

4. Verfahren nach Anspruch 3, wobei die anderen Speicherzellen in einem anderen Gebiet des Speicherbauelements oder in einem anderen Speicherbauelement liegen.

5. Verfahren nach einem der Ansprüche 1 bis 4, wobei das Verfahren für verschiedene Gruppen wiederholt ausgeführt wird.

6. Verfahren nach dem auf Anspruch 2 rückbezogenen Anspruch 5, wobei für jede einzelne Speicherzelle gezählt wird, wie oft sie in Schritt c) umprogrammiert wird, und, wenn diese Zahl bei einer der Speicherzellen eine hierfür vorgegebene Maximalanzahl überschreitet, der neue Datensatz in einer anderen Speicherzelle, insbesondere in einem anderen Gebiet des Speicherbauelements oder in einem anderen Speicherbauelement, hinterlegt wird.

7. Verfahren nach dem auf Anspruch 2 rückbezogenen Anspruch 5, wobei für jede einzelne Speicherzelle gezählt wird, wie oft sie in Schritt c) umprogrammiert wird, und, wenn diese Zahl bei einer der Speicherzellen eine hierfür vorgegebene Maximalanzahl überschreitet, eine Fehlermeldung abgegeben und ggf. das Verfahren abgebrochen wird.

8. Verfahren nach einem der Ansprüche 5 bis 7, wobei gezählt wird, wie oft der Schritt c) insgesamt ausgeführt wird, und bei Überschreiten einer hierfür vorgegebenen Maximalanzahl eine Fehlermeldung abgegeben und ggf. das Verfahren abgebrochen wird.

9. System zur Durchführung des Verfahrens nach einem der Ansprüche 1 bis 8, mit:
- einem schaltungsprogrammierbaren Speicher (2);
- einem Mittel (3) zum Vergleichen der Datensätze einer Gruppe;
- einem Mittel (5), das dazu eingerichtet ist, bei Nichtübereinstimmung eines Datensatzes der Gruppe mit den übrigen Datensätzen der Gruppe diesen als ungültig zu erkennen und die übrigen, übereinstimmenden Datensätze als gültig zu erkennen; und
- einem Mittel (6) zum Korrigieren des ungültigen Datensatzes durch Ersetzen durch einen gültigen Datensatz.

10. System nach Anspruch 9, bei welchem das Mittel (6) zum Korrigieren dazu eingerichtet ist, das Ersetzen des ungültigen Datensatzes durch Umprogrammieren der Speicherzelle, in der sich dieser befindet, zu erzielen.

11. System nach Anspruch 9 oder 10, bei welchem das Mittel zum Korrigieren (6) dazu eingerichtet ist, das Ersetzen des ungültigen Datensatzes durch Hinterlegen des neuen Datensatzes in anderen Speicherzellen, insbesondere in einem anderen Gebiet des Speicherbauelements oder in einem anderen Speicherbauelement, zu erzielen.

12. System nach einem der Ansprüche 9 bis 11, welches für ein wiederholtes Erkennen und Korrigieren ungültiger Datensätze verschiedener Gruppen eingerichtet ist.

13. System nach dem auf Anspruch 10 rückbezogenen Anspruch 12, welches außerdem ein Mittel (7) zum Zählen, wie oft eine Korrektur für jede einzelne Speicherzelle ausgeführt wird, und ein Mittel, das bei Überschreiten einer hierfür vorgegebenen Maximalanzahl veranlaßt, daß der neue Datensatz in anderen Speicherzellen, insbesondere in einem anderen Gebiet des Speicherbauelements oder in einem anderen Speicherbauelement, hinterlegt wird, umfaßt.

14. System nach dem auf Anspruch 10 rückbezogenen Anspruch 12, welches außerdem ein Mittel zum Zählen (7), wie oft eine Korrektur für jede einzelne Speicherzelle ausgeführt wird, und ein Mittel, das bei Überschreiten einer hierfür vorgegebenen Maximalanzahl eine Fehlermeldung abgibt und ggf. einen Abbruch des Verfahrens veranlaßt, umfaßt.

15. System nach einem der Ansprüche 12 bis 14, welches außerdem ein Mittel zum Zählen (8), wie oft insgesamt eine Korrektur ausgeführt wird, und ein Mittel, das bei Überschreiten einer hierfür vorgegebenen Maximalanzahl eine Fehlermeldung abgibt und ggf. einen Abbruch des Verfahrens veranlaßt, umfaßt.

16. System nach einem der Ansprüche 9 bis 15, bei welchem die oder einige der Mittel (3, 5, 6, 7, 8) zum Vergleichen, Erkennen und Korrigieren von Datensätzen, Zählen von Korrekturen, Abgeben von Fehlermeldungen und Abbrechen des Verfahrens durch wenigstens einen geeignet programmierten Mikrocomputer gebildet werden.
